# EUROPEAN PATENT APPLICATION

(11) **EP 4 769 413 A1**
(43) Date of publication of application: **01.07.2026**
(21) Application number: 25216028.8
(22) Date of filing: 14.11.2025
(51) Int. Cl.: G11C 29/02, G11C 29/26

(54) **MEMORY TEST ALGORITHMS FOR 3D INTEGRATED CIRCUITS (IC)**

(30) Priority: 27.12.2024 US 202419003815
(71) Applicant: INTEL Corporation, Santa Clara, CA 95054 (US)
(72) Inventor: KANDULA, Rakesh, 560035 Bangalore (IN); SWAMY, Savitha, 560085 Bangalore (IN)
(74) Representative: HGF

(57) **Abstract**

Devices and methods for testing interconnect lanes of multichip packages with memory test algorithms are provided. The multichip packages that can be tested can comprise a plurality of semiconductor dies mounted on an active interposer.

## Description

### FIELD

Descriptions are generally related to semiconductor devices, and more particular descriptions are related to testing multichip packages that can include stacked dies, high density interconnects, interposers, and systems on a chip.

### BACKGROUND

Semiconductor chips are central to intelligent devices and systems, such as personal computers, laptops, tablets, phones, servers, and other consumer and industrial products and systems. Manufacturing semiconductor chips presents a number of challenges and these challenges are amplified as devices become smaller and performance demands increase. Challenges include, for example, unwanted material interactions, precision and scaling requirements, power delivery requirements, limited failure tolerance, and material and manufacturing costs.

Semiconductor devices comprising a system on a chip (SOC) can integrate what are referred to as partitions or blocks into a monolithic die. The SOC can include, for example, a central processing unit (CPU), a graphics processing unit (GPU), an image processing unit (IPU), a neural processing unit (NPU), a bus interface unit (BIU), and/or a data streaming accelerator (DSA). As a result, die size has increased and resulted in significant manufacturing cost implications. Package-level integration can reduce some of the negative manufacturing cost implications of SOC integration. Various package motifs are possible, such as, for example, 2D planar multichip packages (MCPs), 3D packages (for example, 2 or more dies on a base die) or other types stacked and/or side-by-side MCPs. Multi-chip packages can provide a small form-factor and high density of dies and die interconnects having small pitches. The shorter and smaller the interconnect lines, the smaller the parasitic capacitance and latencies, which can lead to superior performance in MCPs.

### BRIEF DESCRIPTION OF THE DRAWINGS

The figures are provided to aid in understanding the disclosure. The figures can include diagrams and illustrations of examples of structures, assemblies, data, methods, and systems. For ease of explanation and understanding, these structures, assemblies, data, methods, and systems, the figures are not an exhaustively detailed description. The figures therefore should not be understood to depict the entire metes and bounds of structures, assemblies, data, methods, and systems possible without departing from the scope of the disclosure. Additionally, features are not necessarily illustrated relatively to scale due in part to the small sizes of some features and the desire for clarity of explanation in the figures.
**Figure 1** provides an example of a multichip package (MCP) assembly.
**Figure 2** shows transmit circuitry that can be part of the circuitry of a semiconductor die.
**Figure 3** illustrates receive circuitry that can be part of the circuitry of a semiconductor die.
**Figure 4** provides a view of a memory built-in self test (MBIST) controller and interface logic.
**Figure 5** shows a transmit architecture for a semiconductor die that includes a MBIST bridge.
**Figure 6** shows a receive architecture for a semiconductor die that includes a MBIST bridge.
**Figure 7** illustrates a multichip package architecture that includes MBIST functionality for testing input/output lanes between chips.
**Figure 8** diagrams a method for using a MBIST algorithm on a the interconnect lanes of a multi-chip package (MCP).
**Figure 9** provides an example of a computing system.

Descriptions of certain details and implementations follow, including non-limiting descriptions of the figures, which depict some examples and implementations.

### DETAILED DESCRIPTION

References to one or more examples are to be understood as describing a particular feature, structure, or characteristic included in at least one implementation. The phrases "one example" or "an example" are not necessarily all referring to the same example or embodiment. Any aspect described herein can potentially be combined with any other aspect or similar aspect described herein, regardless of whether the aspects are described with respect to the same figure or element.

The words "connected" and/or "coupled" can indicate that two or more elements are in direct physical or electrical contact with each other. The term "coupled," however, can also mean that two or more elements are not in direct contact with each other and are instead separated by one or more elements but they may still co-operate or interact with each other, for example, physically, magnetically, optically, or electrically.

The words "first," "second," and the like, do not indicate order, quantity, or importance, but rather are used to distinguish one element from another. The words "a" and "an" herein do not indicate a limitation of quantity, but rather denote the presence of at least one of the referenced items. The terms "follow" or "after" can indicate immediately following or following some other event or events. Other sequences of operations can also be performed according to alternative embodiments. Furthermore, additional operations may be added or removed depending on the application.

Disjunctive language such as the phrase "at least one of X, Y, or Z," is used in general to indicate that an element or feature, may be either X, Y, or Z, or any combination thereof (e.g., X, Y, and/or Z). Thus, this disjunctive language should be understood not to imply that certain embodiments require at least one of X, at least one of Y, or at least one of Z to each be present.

Flow diagrams as illustrated herein provide examples of sequences of various process actions. The flow diagrams can indicate operations to be executed by a software or firmware routine, as well as by physical operations. Operations can be performed by semiconductor testing equipment, including computer systems that run testing protocols and operate aspects of testing equipment and systems. Although shown in a particular sequence or order, unless otherwise specified, the order of the actions can be modified. Thus, the illustrated diagrams should be understood as examples. The processes can be performed in a different order, and some actions can be performed in parallel. Additionally, one or more actions can be omitted and not all implementations may necessarily perform all actions.

Various components described can be a means for performing the operations or functions described. Components described can include software, hardware, or a combination of these. Some components can be implemented as software modules, hardware modules, special-purpose hardware (for example, application specific hardware, application specific integrated circuits (ASICs), and digital signal processors (DSPs)), embedded controllers, and/or hardwired circuitry. Other components can be semiconductor processing and/or testing equipment that is able to perform physical operations such as, for example, lithography, probing, material deposition (for example, chemical vapor deposition, atomic layer deposition, physical vapor deposition, electrodeposition, and/or sputtering), chemical mechanical planarization (CMP), and etching.

To the extent various computer operations or functions are described herein, they can be described or defined as software code, instructions, configuration, and/or data. The software content can be provided via an article of manufacture with the content stored thereon, or via a method of operating a communication interface to send data via the communication interface. A machine-readable storage medium can cause a machine to perform the functions or operations described. A machine-readable storage medium includes any mechanism that stores information in a tangible form accessible by a machine (e.g., computing device), such as recordable/non-recordable media (e.g., read only memory (ROM), random access memory (RAM), magnetic disk storage media, optical storage media, flash memory devices). Instructions can be stored on the machine-readable storage medium in a non-transitory form. A communication interface includes any mechanism that interfaces to, for example, a hardwired, wireless, or optical medium to communicate to another device, such as, for example, a memory bus interface, a processor bus interface, an Internet connection, a disk controller.

Terms such as chip, die, IC (integrated circuit) chip, IC die, microelectronic chip, microelectronic die, semiconductor die, semiconductor device, and/or semiconductor chip are interchangeable and refer to a device comprising integrated circuits that can be formed in part from semiconductor materials.

Semiconductor chip manufacturing processes are sometimes divided into front end of the line (FEOL) processes and back end of the line (BEOL) processes. Electronic circuits and active and passive devices within the chip, such as for example, transistors, capacitors, resistors, and/or memory cells, are manufactured in what can be referred to as FEOL processes. Memory cells include, for example, electronic circuits for random access memory (RAM), such as static RAM (sRAM), dynamic RAM (DRAM), read only memory (ROM), non-volatile memory, and/or flash memory. FEOL processes can be, for example, complementary metal-oxide semiconductor (CMOS) processes. BEOL processes include metallization of the chip where interconnects are formed in layers and the feature size of the interconnect increases in layers nearer the surface of the semiconductor chip. Interconnects in, for example, semiconductor chips that are integrated into heterogeneous packages (such as, for example, packages that include memory and logic chips), can also include through silicon vias (TSVs) that transverse the semiconductor chip device region. Semiconductor devices that have TSVs can blur distinctions between BEOL and FEOL processes.

Semiconductor chip interconnects can be created by forming a trench or though-layer via by etching a trench or via structure into a dielectric layer and filling the trench or via with metal. Dielectric layers can comprise, for example, low-κ dielectrics, SiO₂, silicon nitride (SiN), silicon carbide (SiC), and/or silicon carbonitride (SiCN). Low-κ dielectrics include for example, fluorine-doped SiO₂, carbon-doped SiO₂, porous SiO₂, porous carbon-doped SiO₂, combinations for the foregoing, and also these materials with gas-filled gaps or bubbles. Dielectric layers that include conductive features can be interlayer dielectric (ILD) features. In general, low-κ dielectrics exhibit a dielectric constant that is less than that of SiO₂.

The terms "package," "packaging," "IC package," or "chip package," "microelectronics package," or "semiconductor chip package" are interchangeable and generally refer to an enclosed carrier of one or more chips, in which the chips are coupled to a package substrate and encapsulated. The package substrate provides electrical interconnections between the chip(s) and other chips and/or a motherboard or other circuit board for I/O (input/output) communication and power delivery. A package with multiple chips can, for example, be a system in a package.

A package substrate generally includes dielectric layers or structures having conductive structures on, through, and/or embedded in the dielectric layers. The dielectric layers can be, for example, build-up layers. Dielectric materials include Ajinomoto build-up film (ABF), although other dielectric materials are possible. Semiconductor package substrates can have cores or be coreless. Semiconductor packages having cores can have dielectric layers such as buildup layers on more than one side of a core, such as on two opposite sides of a core. Cores can include through-core vias that contain a conductive material. Other structures or devices are also possible within a package substrate.

A "core" or "package core" generally refers to a layer usually embedded within a package substrate. The core can provide structure or stiffness to a package substrate. A core is an optional feature of a package substrate. The core can be a dielectric organic or inorganic material and may have conductive vias extending through the layer. The conductive vias can include a metal, for example, copper. A package core can, for example, be comprised of a glass material (such as, for example, aluminosilicate, borosilicate, alumino-borosilicate, silica, and fused silica), silicon, silicon nitride, silicon carbide, gallium nitride, or aluminum oxide. In some examples, core materials are glass-fiber reinforced organic resins such as epoxy-based resins. A further example package substrate core is FR4 (woven glass fiber reinforces epoxy). In other examples, package substrate cores are solid amorphous glass layers.

In further examples of a package substrate core, the substrate core is a glass core comprising one or more solid amorphous glass layers. The glass substrate core can comprise a glass such as, for example, aluminosilicate, borosilicate, alumino-borosilicate, silica, and fused silica, that additionally optionally comprises one or more of the following: Al₂O₃, B₂O₃, MgO, CaO, SrO, BaO, SnO₂, Na₂O, K₂O, SrO, P₂O₃, ZrO₂, Li₂O, Ti, and/or Zn. In further examples of glass cores, the glass can comprise silicon and oxygen, as well as optionally any one or more of: aluminum, boron, magnesium, calcium, barium, tin, sodium, potassium, strontium, phosphorus, zirconium, lithium, titanium, and/or zinc. In some examples, a glass package substrate core comprises at least 23 % silicon, at least 26 % oxygen by weight. In further examples, the glass package substrate core comprises at least 23 % silicon, at least 26 % oxygen, and at least 5 % aluminum by weight.

Additionally, examples of solid amorphous glass substrate cores can be considered to have a rectangular prism volume. The rectangular prism volume can contain vias that have been filled with one or more different materials. A material in a via can be a conductive metal such as copper. Examples of solid amorphous glass substrate cores can have a thickness in the range of 50 µm to 1.4 mm. Additionally, the package substrate can include a multi-layer glass substrate. The package substrate in this example may be a coreless substrate. The multi-layer glass substrate can have a thickness, for example, in the range of 25 µm to 50 µm. Further, glass substrate cores can have dimensions on a side of 10 mm to 250 mm. For example the substrate core can be 10 mm by 10 mm up to 250 mm by 250 mm in two dimensions, but substrate cores do not necessarily have to have the same value in both dimensions.

A package substrate can include one or more interconnect bridges. The interconnect bridge can be partially, fully, or not embedded into the package substrate. An interconnect bridge provides interconnects between chips that are housed on the package substrate. The interconnects can provide signal I/O between the chips. Some interconnect bridges, such as ones that have conductive through-bridge vias, can also provide power to an operably connected chip. The interconnect bridge can include regions having traces that have a smaller width dimension (the smallest dimension of the trace), a smaller height dimension, and/or a length dimension than the vias and traces of the surrounding package substrate. For example, width dimensions (or smallest dimension) can be 3 µm or less and/or 10 µm or less in some regions. The interconnect bridges can also have smaller trace spacings than the surrounding package substrate. For example, trace center-to-center spacings can be 3 µm and/or less or 10 µm or less in some regions. The interconnect bridge substrate can comprise, for example, silicon, silicon-on-insulator, float glass, borosilicate glass, silicon dioxide, polymeric, one or more organic polymeric materials, ceramic, and/or a silicon nitride material. The interconnect bridge substrate can comprise, for example, one or more dielectric layers that are comprise of, silicon oxides, silicon nitride, silicon oxynitride, carbon-doped oxide, methyl silsesquioxane, hydrogen silsesquioxane, die backside film (DBF), an epoxy film, a B-stage epoxy film, other dielectric material. The interconnect bridge can also include a coreless substrate comprised of a plurality of dielectric layers. The dielectric layers can be, for example, die backside film (DBF), an epoxy film, a B-stage epoxy film, or other dielectric material. Other materials are also possible for interconnect bridge substrates. Other materials are possible.

Incorporating through-bridge vias (TBVs) into interconnect bridges can enable power to be routed from a substrate package cavity to a semiconductor device attached to a package substrate. Through-bridge-vias can reduce the number of substrate routing layers required in a package substrate and can result in improved packaging yields. An interconnect bridge having TBVs can be for example, EMIB with TBVs, or EMIB-T. Depending on the bridge substrate material, a TBV may also be described as a through-silicon via (TSV) if the via traverses a region comprised of silicon, for example.

In some multichip package MCP architectures, the connectivity between the top dies can be done through a base die, using interface ports (one on each of the top dies). This type of connectivity can be called D2D (Die-to-Die) interconnectivity.

The attachment of the top die(s) onto a base die can be associated with process yield challenges, since the I/O (input output) micro bump pitch is increasingly reduced for interconnects formed during assembly processes. Failure modes during interconnect formation (e.g., bump bonding technologies) include hard defects such as opens and shorts formed through, for example, misalignments. Hard defects can be randomly placed. Failure modes for packaged dies also include systematic failures. Systematic failure modes can occur from design marginality discovered under PVT (process, voltage, temperature) variations and can be, for example, related to process variation of lithographic critical dimensions (CDs) or implant profiles on a wafer's edge, among other things.

A built-in self-test IC controller for MCPs can comprise the following registers that are programmable according to Joint Action Test Group (JTAG) Institute of Electrical and Electronics Engineers (IEEE 1149.1) standard protocol.
a) Failing lane registers: A register width is equal to Log2(total number of lanes). There can be 3 failing lane registers:
   - failing lane 1 register,
   - failing lane 2 register, and
   - failing lane 3 register.
   These registers can record up to 3 failing lanes. There can 2 repair lanes. The third lane can be dedicated to providing additional failure analysis data.
   For example, if there are 100 lanes, the width of the register is 7. If lane 10, lane 27, and lane 31 are failing, then:
   - the failing lane1 register records 10,
   - the failing lane2 register records 27, and
   - the failing lane3 register records 31.
b) Per Lane Error Register: This register is as wide as the number of lanes. This register records per lane error information and this register is set to 1 by the hardware if there is a lane failure.
   For example, if there are 10 lanes, the width of the register is 10. If lane 5 and lane 7 are failing then the register bit 5 and register bit 7 records 1: 10'b0001010000.
c) Error Injection Register: This register is as wide as number of lanes. If a particular bit is set to 1 by the user, the corresponding lane can be fault injected.
   For example, if there are 10 lanes, the width of this register is 10. If the user intends to inject artifact error into lane 4, then the bit 4 is set to 1 by the user.

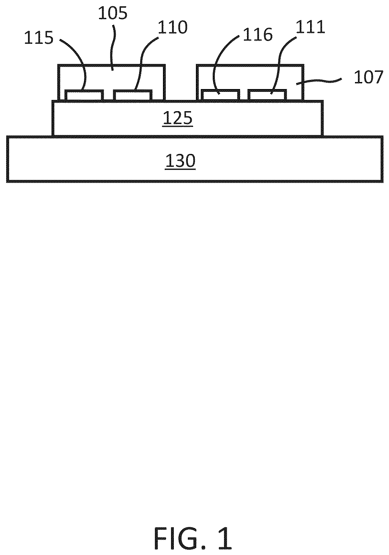

Figure 1 provides an example of a multichip package. The MCP includes a first semiconductor die 105 and a second semiconductor die 107. The first semiconductor die 105 includes transmit circuitry 115 and receive circuitry 110 and the second semiconductor die 107 includes transmit circuitry 116 and receive circuitry 111. The first semiconductor die 105 and the second semiconductor die 107 are electrically coupled to a third semiconductor die 125. The first semiconductor die 105 and second semiconductor die 107 can be attached to the third semiconductor die 125 through I/O micro bumps that have increasingly smaller pitches as technology nodes scale down. The base semiconductor die 125 can electrically connected to a package substrate 130 though conducting interconnects (not shown).

In Figure 1, the integrity of the connectivity of each lane (interconnect I/O) between semiconductor dies (e.g., semiconductor dies 105, 106, and 107) can be tested by a memory built-in self test (MBIST) machine in which the two sides of the top dies act in mode of Tx/Rx (transmit/receive).

A cluster can include hundreds of transmit circuitry 115 and 116 units and hundreds of receive circuitry 110 and 111 units. A typical cluster can contain as many as 500 transmit circuitry units and 500 receive circuitry units or more. The number of transmit units can be equal to the number of receive units, both of which can be the same as the number of signals crossing a semiconductor die. The transmit units in a cluster can be controlled by single transmit BIST and/or MBIST controller and receive units in a cluster can be controlled by a single receive BIST and/or MBIST controller. Transmit units and receive units can include a) Functional Flop, b) Functional Path to be tested, and c) Testing Circuits.

The integrity of the connectivity of each lane can be tested by built-in self-test (BIST) circuits in which the two sides of the top dies can act in Tx/Rx (signal transmit/receive) mode.

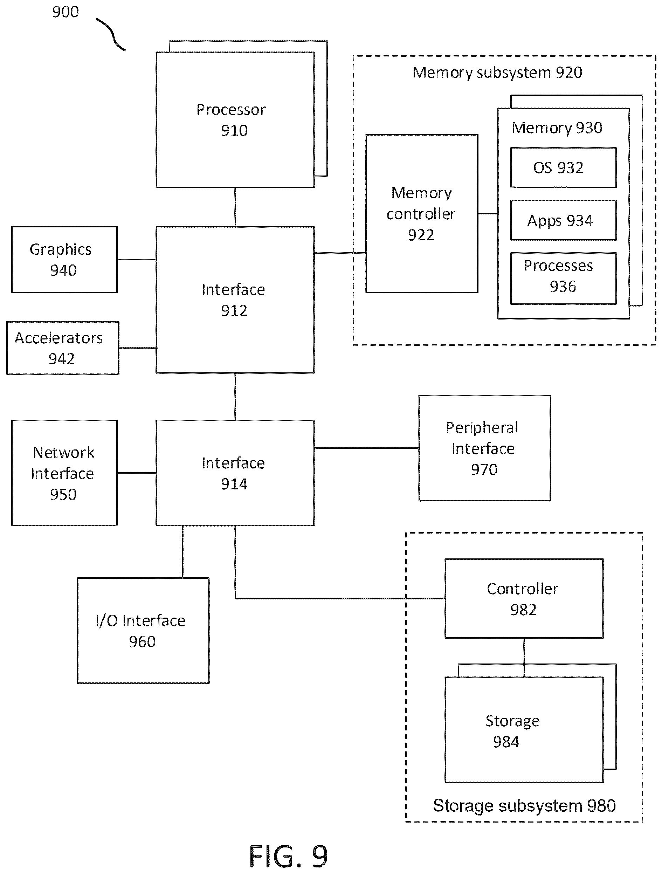

The semiconductor dies 105, 107, and 125 (and 505) can be any combination of microprocessors, CPUs (central processing units), GPUs (graphics processing units), processing cores, system on a chips, other processing hardware, a combination of processors or processing cores, programmable general-purpose or special-purpose microprocessors, accelerators, DSPs, I/O management, programmable controllers, ASICs, programmable logic devices (PLDs), interposers, active interposers, HBM, and/or other memory devices. The semiconductor chips can be any of the chips, for example, described herein with respect to Figure 9. For example, the first semiconductor die 105 can be a compute chip, the second semiconductor die 107 can be a SOC chip, and the third semiconductor die 125 can be an active interposer comprising circuitry. The semiconductor chip packages described herein generally can be part of various larger package structures and configurations and the foregoing example is not meant to limit the types of assemblies that are possible.

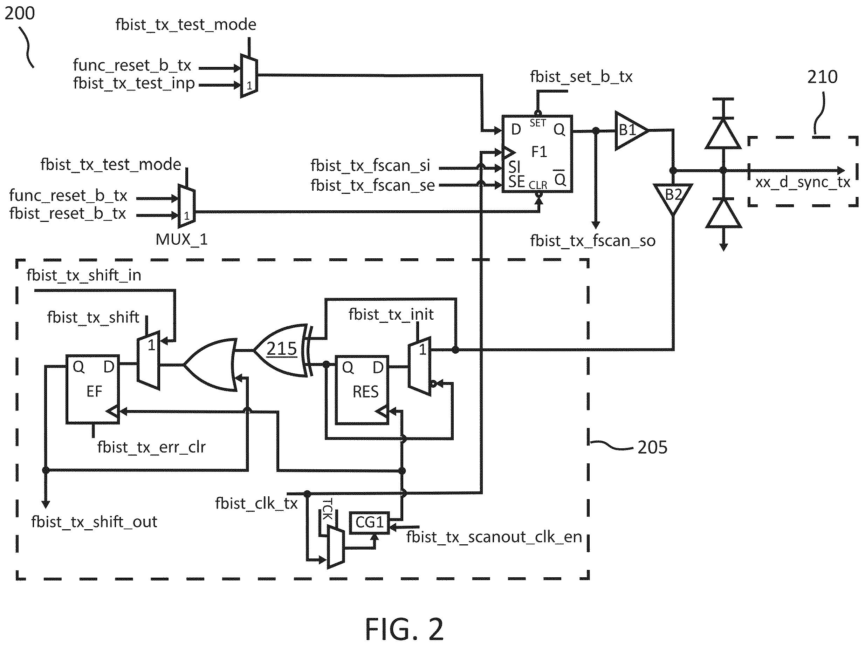

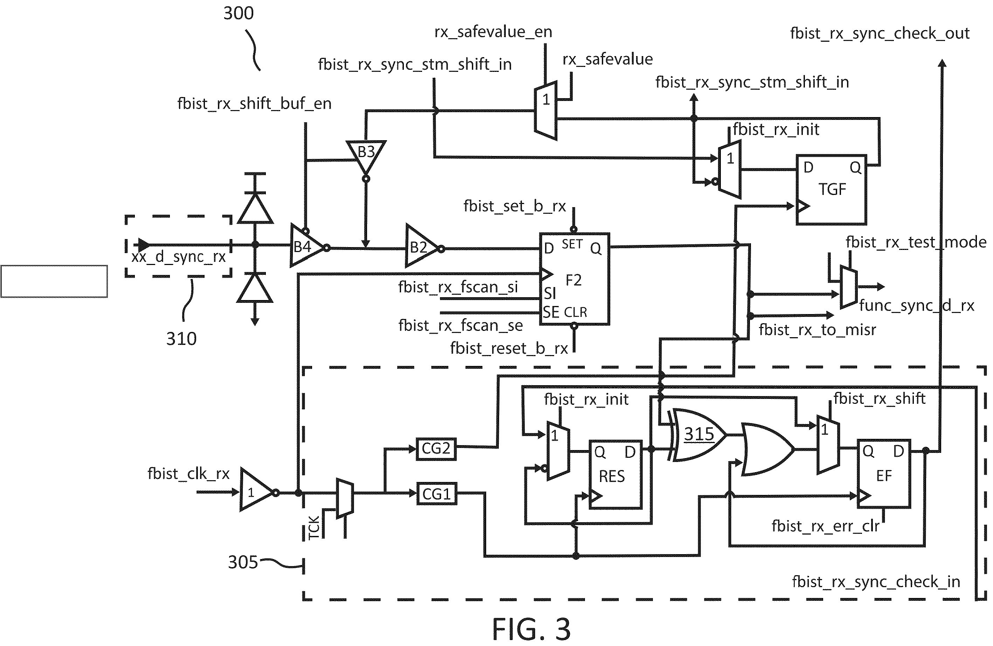

Figure 2 provides an example of a transmit circuit unit 200 which can be, for example, the transmit circuitry 115 or 116 of Figure 1. In Figure 2, F1 is a functional flop. Test circuity is demarcated by a first dashed line 205. A functional path to be tested can be F1 -> B1 - > B2. A second dashed line 210 demarcates a signal IO lane to, for example, a lane between a first semiconductor die and a second semiconductor die. The first semiconductor die can be the semiconductor die 105, the second semiconductor die can be the semiconductor die 107, and the signal IO lane can traverse a third semiconductor die, such as semiconductor die 125 of Figure 1. The circuitry CG1 is clock gating circuitry. In Figure 3, a dashed line box demarcates a signal I/O lane 310 that could, for example, be electrically coupled to the signal I/O lane 210.

Figure 3 provides an example of a receive circuit unit 300 which can be, for example, the receive circuitry 110 or 111 of Figure 1. In Figure 3, F2 is a functional flop. Test circuity is demarcated by a first dashed line 305. Test circuitry can also include the block labeled TGF. The circuitry CG1 and CG2 are clock gating circuitry. A functional path to be tested can include B4 -> B2.

The F1 and F2 functional flops can be part of the functional logic to be tested. The functional flops F1 and F2, are run on a muxed clock between functional clock and slow test clock. The clock to the F1 and F2 flops is controlled by clock gating cell CG1. The input clock to the clock gate CG1 is a muxed clock between a slow-speed test clock and a full speed functional clock. The clock gating enable and the clock select are generated by the finite state machine (FSM) that is internal to the TX and RX circuits.

The functional path crossing is a crossing through a 3D IC or through link between F1 in a transmitting die and F2 on a receiving die. The crossing can include: F1 (on Tx Die) -> B1 (on Tx Die) -> B4(on Rx die) -> B2(On Rx die) -> F2(on Rx die).

In Figure 2, a testing circuit can comprise: a RES flop, a comparator, and an EF flop. RES flop is the result generating flop. The RES flop can generate a toggle pattern and compare against the test_input coming through the F1 flop. The clock to the RES flop is controlled by clock gate CG1. Test input is generated by test controller and is also a toggle pattern. Test_input toggle pattern traverses through F1. The RES flop on TX circuits can be used for sort testing, i.e., testing before TX die is packaged with a RX die. The RES flop on RX circuits can be used for both sort (die-level) and class (packaged die) testing.

The comparator 215 can be an XOR gate for which inputs are RES output and F1 output through B1 (in the functional path of the TX circuitry). If, for example, the two inputs of XOR gate do not match, its output is 1. The comparator 215 in the TX circuitry can be used for sort testing, i.e., testing before TX die is packaged with a RX die. The comparator 315 in the RX circuitry can be used for both sort (die-level) and class (packaged die) testing.

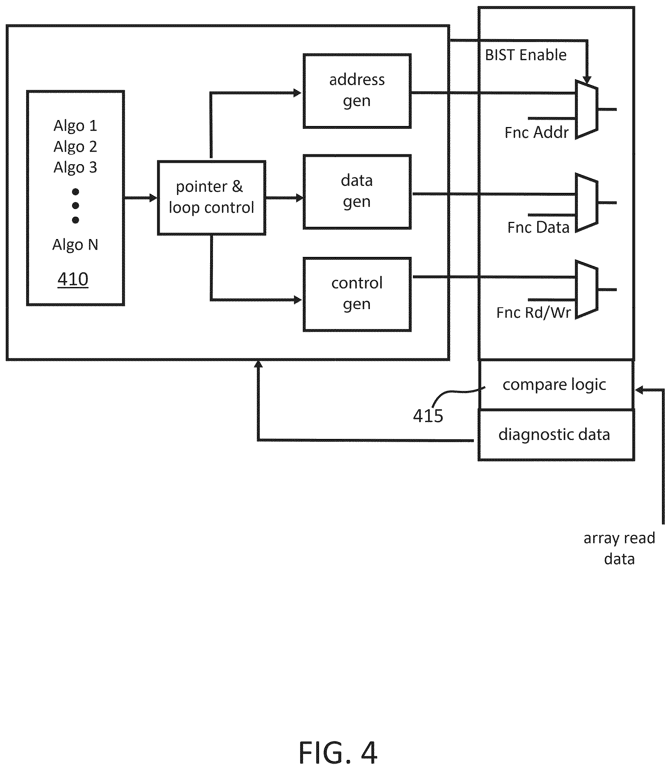

Figure 4 provides a diagram of an example memory BIST (MBIST) controller. A finite state machine (FSM) 410 in the controller can control the sequence of events for executing a specific algorithm. The data read out from the memory is compared with expected data in comparator logic 415. Comparator logic 415 can be placed either in the BIST controller or in the MBIST interface (Collar). The BIST_DONE indicates the completion of the algorithm execution and BIST_GO indicates any difference between data from memory and expected data. The MBIST algorithm can work on memory arrays that typically include address(addr), write enable(wen), write_data(di). The readout data from memory modules can be connected to comparator logic 415.

A MBIST algorithm can have a write sequence:
1) Choose an address to "n bit" write data, where "n bit" is generally a multiple of 1 byte/8 bits,
2) Set the write enable,
3) Choose a pattern in the write data, and
4) Read back the data.

A number of different algorithms can be used for testing. There are at least 50 or more memory testing algorithms available (e.g., checkerboard, March C-, March X, March Y, March A, March B, March C, Partial Moving Inversion (PMOVI), March Algorithm Test Sequence for Pattern-Dependent Write (MATSPDW), and Galloping Pattern (GALPAT)). March C- is an algorithm that detects stuck-at faults, transition faults, and coupling faults. March X is a simpler version of March tests that is primarily used for detecting stuck-at faults. March Y is similar to March X but with a different sequence to detect additional faults. March B is another variant with a different sequence for fault detection. March C is a comprehensive test for various memory faults. For example, a checkerboard algorithm writes 1's and 0's into alternate locations of an array in a checkerboard pattern. The algorithm divides the cells into two alternate groups such that every neighboring cell is in a different group. A checkerboard algorithm can consist of the following elements:
1) Write checkerboard with up addressing order,
2) Read checkerboard with up addressing order,
3) Write inverse checkerboard with up addressing order, and
4) Read inverse checkerboard with up addressing order.

A second MBIST algorithm is Partial Moving Inversion (PMOVI). A PMOVI algorithm can have the following elements:
1) Array is initialized to a known data background in the decreasing order of address,
2) Read data, write data inverse, read data inverse from the first address,
3) Increment the address,
4) Repeat steps 2 and 3 till last address,
5) Read data inverse, write data, read data from the first address,
6) Increment the address,
7) Repeat steps 5 and 6 till last address,
8) Read data, write data inverse, read data inverse from the last address,
9) Decrement the address,
10) Repeat steps 8 and 9 till first address,
11) Read data inverse, write data, read data from the last address,
12) Decrement the address, and
13) Repeat steps 11 and 12 till first address.

Multichip packages, such as, for example, the 3D IC package of Figure 1, and packages that include stacked dies on active interposers, can use parallel bus crossings from a first die to a second die.

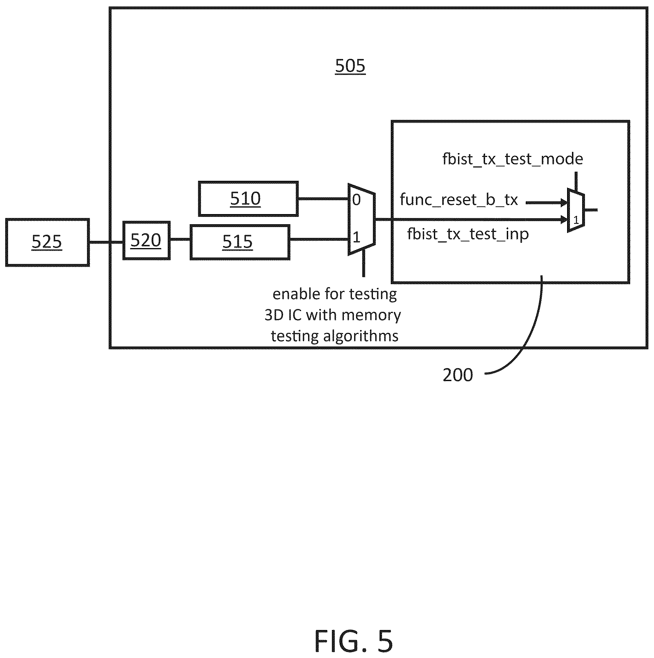

Figure 5 illustrates a transmit (TX) architecture for a semiconductor die 505 that includes a MBIST controller's pattern generator. A semiconductor die 505 that includes transmit circuitry unit 200 (Figure 2), a 3D IC test controller 510, and a MBIST bridge 515. The MBIST bridge 515 can be operably connected to a MBIST controller 520. A MBIST controller is divided into two components in the present architecture: a pattern generator is located on the transmit die, while the comparator is situated on the receive die. The MBIST controller 520 can be operably coupled to an external memory test controller 525. The MBIST bridge 515 comprises a protocol that can generate: a) test patterns based on a selected algorithm from 50 or more distinct memory test algorithms, b) the specific 'memory' addresses where the test patterns will be written, and c) the corresponding write enable signal. The I/O lanes between a TX of a first die and an RX of a second die are segmented into byte-aligned sections. For example, for a 64 lane design:
1) the address 8'd0 are allocated to lanes 0 through 7,
2) lanes 8 through 15 are assigned the address 8'd8, and
3) this pattern is continued for the remaining lanes until ultimately lanes 56 through 63 would be assigned the address 8'd56.
When the MBIST controller 520 issues an 8-bit test data write to address 0, the MBIST bridge 515 directs this data to lanes 0 through 7. Similarly, when the MBIST controller 520 writes 8-bit test data to address 7, the MBIST bridge 515 routes this data to lanes 56 through 63. This architectural design can allow memory test (MBIST) algorithms to be applied for testing 3D IC semiconductor assemblies. MBIST controller 520 can be, in general, a MBIST pattern generator. The MBIST bridge 515 is a bridge between the MBIST controller and the TX/RX lanes. The MBIST bridge 515 understands how to route data to TX/RX lanes according to the 'addresses' that are used by memory testing algorithms.

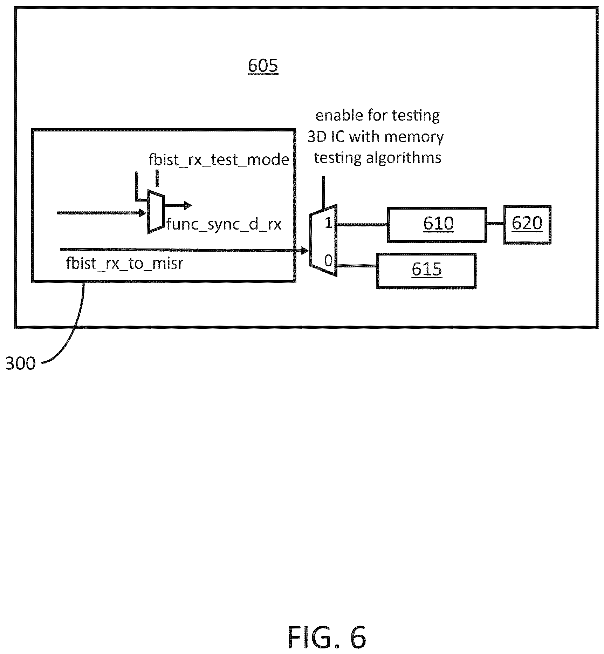

Figure 6 provides a receive (RX) architecture for a semiconductor die 605 that includes a MBIST controller's comparator. A semiconductor die 605 that includes receive circuitry unit 300 (Figure 3), a MBIST comparator bridge 610, a 3D IC test controller 615, and a MBIST controller comparator 620. The data transmitted from the TX lanes can be delivered to the MBIST controller comparator 620, accompanied by an address. The address can determined based on the positioning of the I/O lanes. The MBIST bridge 515 on the TX die assigns the corresponding address to the data, and the combined address and data are then transmitted into the MBIST controller's comparator 620 located on the receive die. For example, if data represented as 8'd1 emerges from lanes 8 to 15, the data presented to the MBIST controller comparator 620 will be 8'd7, and the address relayed to the MBIST Controller will be 8'd7. The MBIST controller's comparator 620 receives the address data for comparison. The controller decodes lane 0 to lane 7 is address 0, lane 8 to lane 15 is address 1, and presents the data received along with the address decoding to the MBIST controller's comparator 620

Applying a PMOVI algorithm to a configuration of, for example, 64 I/O lanes, faults within a lane that are affected by the pattern of adjacent lanes can be identified. A MBIST controller can address 64 lanes by mimicking 64 lanes of an 8x8 memory. For example:
Lane 0 to Lane 7 will be mapped to address 3'd0
Lane 15 to Lane 8 will be mapped to address 3'd1
Lane 23 to Lane 16 will be mapped to address 3'd2
Lane 31 to Lane 24 will be mapped to address 3'd3
Lane 39 to Lane 32 will be mapped to address 3'd4
Lane 47 to Lane 40 will be mapped to address 3'd5
Lane 55 to Lane 48 will be mapped to address 3'd6
Lane 56 to Lane 63 will be mapped to address 3'd7
If, for example, a bit 0 at address 3'd1 has a defect due to a neighbor pattern sensitive fault (NPSF), when the pattern in the neighboring cells is {0->1 0 0} then bit 0 will change from 0 to 1. The PMOVI sequence is designed to identify such a fault. PMOVI element 2 can detect this fault. Similarly, if, for example, lane 8 is defective, a 0->1 transition on lane 0, 0 on lane 9 and 0 on lane 16 will cause lane 8 to change from an initial value of 0 to 1 (an NPSF). This can also be detected with PMOVI sequence. A 0 from lane 8 in the transmitting die is received as 1 in receiving die due to NPSF type fault.

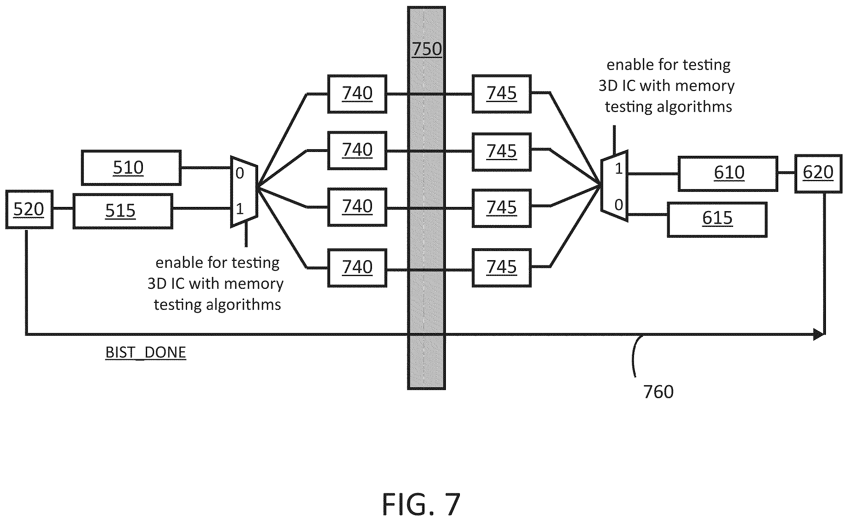

Figure 7 shows MCP architecture for a TX/RX that includes MBIST. Transmit cells 740 on a transmit die are electrically connected to receive cells 745 on a receive die through a third die 750 which can be, for example, an active interposer. The transmit cells 740 can be the transmit circuitry unit 200 of Figure 2, and the receive cells 745 can be the receive circuitry unit 300 of Figure 3. The MBIST controller's pattern generator 520 on the transmit die and the MBIST controller's comparator 620 on the receive die. To communicate the completion of the BIST process to the comparator 620 on the receive die, the pattern generator 520 on the transmit die transmits a 'BIST DONE' signal on lane 760. Lane 760 can optionally be a dedicated lane (die interconnect). The 'BIST_DONE' signal can indicate the appropriate time for the comparator 620 to begin its comparison process.

Within a given cluster, there may be hundreds of transmit cells and an equivalent number of receive cells. For example, a cluster can configuration comprise as many as 500 transmit cells 740 and 500 receive cells 745. (Other numbers are possible.) The number of transmit cells 740 can match the number of receive cells 740 and can correlate with the number of signals that cross between the dies. The transmit cells 740 within a cluster can be managed by a single transmit BIST controller bridge 515, while the receive cells 745 can be governed by a single receive BIST controller bridge 610. Both the transmit cell 740 and the receive cell 745 can include a) a functional flip-flop, b) a functional path that is subject to testing, and c) testing circuits as described herein (e.g., in and with respect to Figures 2 -3).

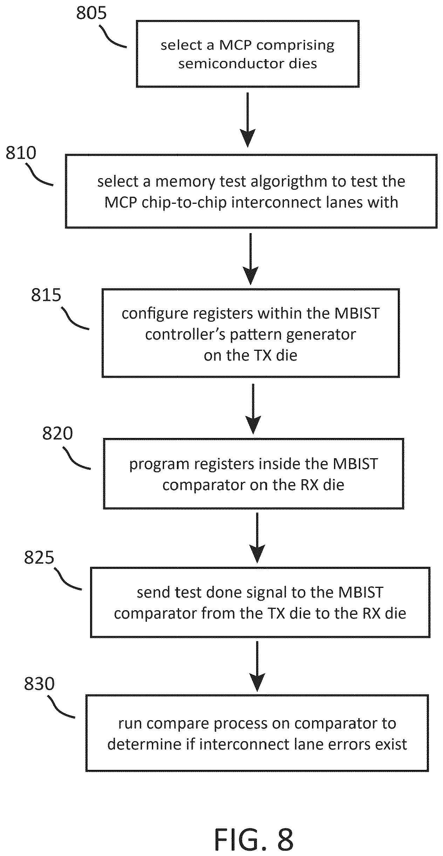

Figure 8 provides a method for performing tests on the interconnect lanes of a MCP using a memory test algorithm. A multichip package is selected for testing (805). In one example, the multichip package can be the include at least two semiconductor dies that are electrically connected to an active interposer so that interconnect signal lanes from the first semiconductor die to the second semiconductor die traverse through the active interposer. A memory test algorithm to be employed is selected (810). The JTAG protocol on the transmit die can be used to configure the programmable JTAG registers within the MBIST controller's pattern generator (815). This configuration can include selecting the test pattern algorithm and determining the duration of the test in clock cycles. The JTAG protocol is employed on the receive die to program the programmable JTAG registers inside the MBIST comparator (820). This programming can aid the comparator to know which data to expect for comparison and the specific timing for when the comparison should occur. A test done (BIST_DONE) signal can be sent to the comparator on the RX die from the TX die (825), to indicate the completion of the BIST process and indicating the appropriate time for the Comparator to begin its comparison process (830).

A bundle, partition, or cluster can be used interchangeably. A partition can refer to the division of a digital circuit design into smaller, more manageable sections or blocks based on functionality, hierarchy, or other design criteria. For example a compute digital circuitry could be partitioned into Instruction Fetch Unit, Instruction Decode Unit, Execution Unit, Cache Memory (L1, L2).

In general, the semiconductor devices (or chips), discussed herein, can be any combination of microprocessors, CPUs (central processing units), GPUs (graphics processing units), processing cores, system on a chips, other processing hardware, a combination of processors or processing cores, programmable general-purpose or special-purpose microprocessors, accelerators, DSPs, I/O management, programmable controllers, ASICs, programmable logic devices (PLDs), active interposers, HBM, and/or other memory devices. These semiconductor chip packages can be heterogeneous packages that incorporate different types of chips into one package. The semiconductor chips can be any of the chips, for example, described herein with respect to Figure 9. The semiconductor chip packages described herein generally can be part of various larger package structures and configurations and the foregoing examples are not meant to limit the types of assemblies that are possible.

Figure 9 depicts an example computing system. The computing system can be a system used for running testing equipment in a semiconductor fabrication plant. For example, instructions for performing one or more aspects of the process described herein can be stored and/or run on the computing system. A computing system 900 can include more, different, or fewer features than the ones described with respect to Figure 9.

Computing system 900 includes processor 910, which provides processing, operation management, and execution of instructions for system 900. Processor 910 can include any type of microprocessor, CPU (central processing unit), GPU (graphics processing unit), processing core, or other processing hardware to provide processing for system 900, or a combination of processors or processing cores. Processor 910 controls the overall operation of system 900, and can be or include, one or more programmable general-purpose or special-purpose microprocessors, DSPs, programmable controllers, ASICs, programmable logic devices (PLDs), or the like, or a combination of such devices.

In one example, system 900 includes interface 912 coupled to processor 910, which can represent a higher speed interface or a high throughput interface for system components needing higher bandwidth connections, such as memory subsystem 920 or graphics interface components 940, and/or accelerators 942. Interface 912 represents an interface circuit, which can be a standalone component or integrated onto a processor die. Where present, graphics interface 940 interfaces to graphics components for providing a visual display to a user of system 900. In one example, the display can include a touchscreen display.

Accelerators 942 can be a fixed function or programmable offload engine that can be accessed or used by a processor 910. For example, an accelerator among accelerators 942 can provide data compression (DC) capability, cryptography services such as public key encryption (PKE), cipher, hash/authentication capabilities, decryption, or other capabilities or services. In some cases, accelerators 942 can be integrated into a CPU socket (e.g., a connector to a motherboard (or circuit board, printed circuit board, mainboard, system board, or logic board) that includes a CPU and provides an electrical interface with the CPU). For example, accelerators 942 can include a single or multi-core processor, graphics processing unit, logical execution unit single or multi-level cache, functional units usable to independently execute programs or threads, application specific integrated circuits (ASICs), neural network processors (NNPs), programmable control logic, and programmable processing elements such as field programmable gate arrays (FPGAs) or programmable logic devices (PLDs). Accelerators 942 can provide multiple neural networks, CPUs, processor cores, general purpose graphics processing units, or graphics processing units can be made available for use by artificial intelligence (AI) or machine learning (ML) models.

Memory subsystem 920 represents the main memory of system 900 and provides storage for code to be executed by processor 910, or data values to be used in executing a routine. Memory subsystem 920 can include one or more memory devices 930 such as read-only memory (ROM), flash memory, one or more varieties of random access memory (RAM) such as static RAM (SRAM), dynamic RAM (DRAM), synchronous DRAM (SDRAM) and/or or other memory devices, or a combination of such devices. Memory 930 stores and hosts, among other things, operating system (OS) 932 that provides a software platform for execution of instructions in system 900, and stores and hosts applications 934 and processes 936. In one example, memory subsystem 920 includes memory controller 922, which is a memory controller to generate and issue commands to memory 930. The memory controller 922 can be a physical part of processor 910 or a physical part of interface 912. For example, memory controller 922 can be an integrated memory controller, integrated onto a circuit within processor 910.

System 900 can also optionally include one or more buses or bus systems between devices, such memory buses, graphics buses, and/or interface buses. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a peripheral component interface (PCI) or PCI express (PCIe) bus, a Hyper Transport or industry standard architecture (ISA) bus, a small computer system interface (SCSI) bus, a universal serial bus (USB), or a Firewire bus.

In one example, system 900 includes interface 914, which can be coupled to interface 912. In one example, interface 914 represents an interface circuit, which can include standalone components and integrated circuitry. In one example, user interface components or peripheral components, or both, couple to interface 914. Network interface 950 provides system 900 the ability to communicate with remote devices (e.g., servers or other computing devices) over one or more networks. Network interface 950 can include an Ethernet adapter, wireless interconnection components, cellular network interconnection components, USB, or other wired or wireless standards-based or proprietary interfaces. Network interface 950 can transmit data to a device that is in the same data center or rack or a remote device, which can include sending data stored in memory.

Some examples of network interface 950 are part of an infrastructure processing unit (IPU) or data processing unit (DPU), or used by an IPU or DPU. An xPU can refer at least to an IPU, DPU, GPU, GPGPU (general purpose computing on graphics processing units), or other processing units (e.g., accelerator devices). An IPU or DPU can include a network interface with one or more programmable pipelines or fixed function processors to perform offload of operations that can have been performed by a CPU. The IPU or DPU can include one or more memory devices.

In one example, system 900 includes one or more input/output (I/O) interface(s) 960. I/O interface 960 can include one or more interface components through which a user interacts with system 900 (e.g., audio, alphanumeric, tactile/touch, or other interfacing). Peripheral interface 970 can include additional types of hardware interfaces, such as, for example, interfaces to semiconductor fabrication equipment and/or electrostatic charge management devices.

In one example, system 900 includes storage subsystem 980. Storage subsystem 980 includes storage device(s) 984, which can be or include any conventional medium for storing data in a nonvolatile manner, such as one or more magnetic, solid state, and/or optical based disks. Storage 984 can be generically considered to be a "memory," although memory 930 is typically the executing or operating memory to provide instructions to processor 910. Whereas storage 984 is nonvolatile, memory 930 can include volatile memory (e.g., the value or state of the data is indeterminate if power is interrupted to system 900). In one example, storage subsystem 980 includes controller 982 to interface with storage 984. In one example controller 982 is a physical part of interface 912 or processor 910 or can include circuits or logic in both processor 910 and interface 914.

A power source (not depicted) provides power to the components of system 900. More specifically, power source typically interfaces to one or multiple power supplies in system 900 to provide power to the components of system 900.

Examples of systems may be implemented in various types of computing, smart phones, tablets, personal computers, and networking equipment, such as switches, routers, racks, and blade servers such as those employed in a data center and/or server farm environment.

### EXAMPLES

An assembly can comprise: at least two semiconductor dies wherein a first semiconductor die of the at least two semiconductor dies includes signal transmission circuitry, wherein the first semiconductor die includes first test circuitry that includes a pattern generator, wherein a second semiconductor die of the at least two semiconductor dies includes receive circuitry and second test circuitry, and wherein the second test circuitry includes a comparator; a first interconnect lane that electrically connects the first semiconductor die with the second semiconductor die of the at least two semiconductor dies, wherein the first test circuitry is capable of assigning an address to the first interconnect lane; and a second interconnect lane that is capable of sending a signal from the first test circuitry to the second test circuitry indicating that a test sequence is done. The assembly also can comprise an active interposer and a part of the first interconnect lanes travel through the active interposer. The assembly can be capable of running a memory test algorithm that tests viability of the first interconnect lane. The first test circuitry can be also capable of assigning addresses to interconnect lanes. The assembly can be capable of running a memory test algorithm that tests the of the first interconnect lane and wherein the memory test algorithm is a Partial Moving Inversion algorithm.

A method can comprise: selecting a multichip package for testing, wherein the multichip package comprises first interconnect lanes that electrically connect a first semiconductor die of the multichip package with a second semiconductor die of the multichip package; selecting a memory test algorithm to test viability of the first interconnect lanes; running the memory test algorithm to test viability of the first interconnect lanes, and determining viability of the first interconnect lanes. The multichip package can also include an active interposer and a part of the first interconnect lane travel through the active interposer. The memory test algorithm can be a Partial Moving Inversion algorithm. The memory test algorithm can be a checkerboard, March, MATSPDW, or GALPAT algorithm. The method can also include configuring registers on the first die with a pattern generator. The method can also include sending a signal to a comparator on the second semiconductor die indicating the memory test is done.

At least one machine-readable storage medium can comprise non-transitory instructions, that when executed by a processor, cause a device to: select a memory test algorithm to test viability of interconnect lanes of a multichip package wherein the interconnect lanes electrically connect a first semiconductor die of the multichip package with a second semiconductor die of the multichip package; run the memory test algorithm to test viability of the interconnect lanes; and determine viability of the interconnect lanes based on results of the memory test algorithm. The multichip package can also include an active interposer and a part of the interconnect lanes travel through the active interposer. The memory test algorithm can be a Partial Moving Inversion algorithm. The memory test algorithm can be a checkerboard, March C-, MATSPDW, or GALPAT algorithm. The instructions can also include configuring registers on the first die with a pattern generator. The instructions can also include sending a signal to a comparator on the second semiconductor die indicating the memory test can be done.

Besides what is described herein, various modifications can be made to what is disclosed and implementations without departing from their scope. Therefore, the illustrations and examples herein should be construed in an illustrative, and not a restrictive sense.

## Claims

1. An assembly comprising:
at least two semiconductor dies wherein a first semiconductor die of the at least two semiconductor dies includes signal transmission circuitry, wherein the first semiconductor die includes first test circuitry that includes a pattern generator, wherein
a second semiconductor die of the at least two semiconductor dies includes receive circuitry and second test circuitry, and wherein the second test circuitry includes a comparator;
a first interconnect lane that electrically connects the first semiconductor die with the second semiconductor die of the at least two semiconductor dies, wherein the first test circuitry is capable of assigning an address to the first interconnect lane; and
a second interconnect lane that is capable of sending a signal from the first test circuitry to the second test circuitry indicating that a test sequence is done.

2. The assembly of claim 1 wherein the assembly also comprises an active interposer and a part of the first interconnect lanes travel through the active interposer.

3. The assembly of claim 1 or claim 2 wherein the assembly is capable of running a memory test algorithm that tests viability of the first interconnect lane.

4. The assembly of any of claims 1-3 wherein the first test circuitry is also capable of assigning addresses to interconnect lanes.

5. A method comprising:
selecting a multichip package for testing, wherein the multichip package comprises first interconnect lanes that electrically connect a first semiconductor die of the multichip package with a second semiconductor die of the multichip package;
selecting a memory test algorithm to test viability of the first interconnect lanes;
running the memory test algorithm to test viability of the first interconnect lanes, and
determining viability of the first interconnect lanes.

6. The method of claim 5 wherein the memory test algorithm is a Partial Moving Inversion algorithm.

7. The method of claim 5 wherein the memory test algorithm is a checkerboard, March, MATSPDW, or GALPAT algorithm.

8. The method of any of claims 5-7 wherein the method also includes configuring registers on the first die with a pattern generator.

9. The method of any of claims 5-8 wherein the method also includes sending a signal to a comparator on the second semiconductor die indicating the memory test is done.

10. At least one machine-readable storage medium comprising non-transitory instructions, that when executed by a processor, cause a device to:
select a memory test algorithm to test viability of interconnect lanes of a multichip package wherein the interconnect lanes electrically connect a first semiconductor die of the multichip package with a second semiconductor die of the multichip package;
run the memory test algorithm to test viability of the interconnect lanes; and
determine viability of the interconnect lanes based on results of the memory test algorithm.

11. The at least one machine-readable storage medium of claim 10 wherein the multichip package also includes an active interposer and a part of the interconnect lanes travel through the active interposer.

12. The at least one machine-readable storage medium of claim 10 or claim 11 wherein the memory test algorithm is a Partial Moving Inversion algorithm.

13. The at least one machine-readable storage medium of claim 10 or claim 11 wherein the memory test algorithm is a checkerboard, March C-, MATSPDW, or GALPAT algorithm.

14. The at least one machine-readable storage medium of any of claims 10 to 13 wherein the instructions also include configuring registers on the first die with a pattern generator.

15. The at least one machine-readable storage medium of any of claims 10-14 wherein the instructions also include sending a signal to a comparator on the second semiconductor die indicating the memory test is done.
